# EUROPÄISCHE PATENTSCHRIFT

(11) **EP 0 489 936 B1**
(45) Veröffentlichungstag und Bekanntmachung des Hinweises auf die Patenterteilung: **02.08.1995**
(21) Anmeldenummer: 90123125.8
(22) Anmeldetag: 03.12.1990
(51) Int. Cl.: G05F 1/44

(54) **Verfahren zum Detektieren einer Amplituden- und Offset-Abweichung zweier etwa 90 elektrisch versetzter siusförmiger Signale sowie Schaltung zur Durchführung dieses Verfahrens und Verwendung dieses Verfahrens für einen Regler**
Method to detect amplitude and offset variations in two electrical sinusoidal signals 90 degrees out of phase and also circuitry to implement this method and the use of this method in a control system
Méthode pour détecter une différence d'amplitude et d'offset de deux signaux électriques sinusoidaux déphasés de 90 degrés, circuit pour réaliser cette méthode et utilisation de cette méthode pour un régulateur

(43) Veröffentlichungstag der Anmeldung: 17.06.1992
(73) Patentinhaber: SIEMENS AKTIENGESELLSCHAFT, 80333 München (DE)
(72) Erfinder: Donat, Albrecht, Dipl.-Ing., W-8520 Erlangen (DE); Schweigert, Ralf, Dipl.-Ing. (FH), W-8523 Baiersdorf (DE)

(56) Entgegenhaltungen:
- DE-A- 2 161 657
- DE-A- 2 907 865
- DE-A- 3 843 108
- US-A- 3 464 022
- US-A- 3 705 980

## Beschreibung

Die Erfindung bezieht sich auf ein Verfahren zum Detektieren einer Amplituden- und Offset-Abweichung zweier gleichartiger, um 90° elektrisch versetzter sinusförmiger Signale S1 und S2 mit vorgegebener Soll-Amplitude mit folgenden Verfahrensschritten, daß eine erste Schwellwertstufe ein erstes Kennsignal als Bedingung A stets solange liefert, wie das Signal S1 die vorgegebene Soll-Amplitude überschreitet, daß eine zweite Schwellwertstufe ein zweites Kennsignal als Bedingung B stets solange liefert, wie das Signal S2 die vorgegebene Soll-Amplitude überschreitet, daß durch eine dritte Schwellwertstufe der Nulldurchgang des Signals S1 sowohl in aufsteigender als auch in absteigender Richtung zu Zeitpunkten 1_{auf} bzw. 1_{ab} detektierbar ist und daß durch eine vierte Schwellwertstufe der Nulldurchgang des Signals S2 sowohl in aufsteigender als auch in absteigender Richtung zu Zeitpunkten 2_{auf} bzw. 2_{ab} detektierbar ist.

Ferner bezieht sich die Erfindung auf eine Schaltung zum Detektieren einer Amplituden- und Offset-Abweichung zweier gleichartiger, um etwa 90° elektrisch versetzter sinusförmiger Signale S1 und S2 mit vorgegebener Soll-Amplitude mit folgenden Merkmalen , daß eine erste Schwellwertstufe ein erstes Kennsignal als Bedingung A stets solange liefert, wie das Signal S1 die vorgegebene Soll-Amplitude überschreitet, daß eine zweite Schwellwertstufe ein zweites Kennsignal als Bedingung B stets solange liefert, wie das Signal S2 die vorgegebene Soll-Amplitude überschreitet, daß durch eine dritte Schwellwertstufe der Nulldurchgang des Signals S1 sowohl in aufsteigender als auch in absteigender Richtung zu Zeitpunkten 1_{auf} bzw. 1_{ab} detektierbar ist und daß durch eine vierte Schwellwertstufe der Nulldurchgang des Signals S2 sowohl in aufsteigender als auch in absteigender Richtung zu Zeitpunkten 2_{auf} bzw. 2_{ab} detektierbar ist.

Ein derartiges Verfahren samt Schaltung ist aus der DE-OS 38 43 108 bekannt. Der zur Durchführung dieses Verfahren beschrittene Weg hat sich zwar in der Vergangenheit bewährt, jedoch ist der schaltungstechnische Aufwand zur Durchführung eines derartigen Verfahrens nicht unerheblich.

Aufgabe der Erfindung ist es, ein Verfahren der eingangs genannten Art so auszubilden, daß mit wenigen einfachen Verfahrensschritten Amplituden- und Offset-Abweichungen detektiert werden können und daß die zur Durchführung des Verfahrens erforderliche Schaltung möglichst einfach realisierbar ist.

Gemäß der Erfindung wird diese Aufgabe bezüglich des gattungsgemäßen Verfahrens dadurch gelöst, daß in einem Steuerwerk die folgende logische Verknpüfung vorgenommen wird:
Es wird ein Ausgangssignal "Amplitude von S1 ist größer als die Soll-Amplitude" generiert, wenn zu aufeinanderfolgenden Zeitpunkten 2_{auf} und 2_{ab} die Bedingung A vorliegt,
es wird ein Ausgangssignal "Amplitude von S1 ist kleiner als die Soll-Amplitude" generiert, wenn zu einanderfolgenden Zeitpunkten 2_{auf} und 2_{ab} die Bedingung A nicht vorliegt,
Es wird ein Ausgangssignal "Offset von S1 ist zu groß" generiert, wenn zu aufeinanderfolgenden Zeitpunkten 2_{auf} die Bedingung A vorliegt und 2_{ab} die Bedingung A nicht vorliegt,
es wird ein Ausgangssignal "Offset von S1 ist zu klein" generiert, wenn zu aufeinanderfolgenden Zeitpunkten 2_{auf} die Bedingung A nicht vorliegt und 2_{ab} die Bedingung A vorliegt,
es wird ein Ausgangssignal "Amplitude von S2 ist größer als die Soll-Amplitude" generiert, wenn zu aufeinanderfolgenden Zeitpunkten 1_{auf} und 1_{ab} die Bedingung B vorliegt,
es wird ein Ausgangssignal "Amplitude von S2 ist kleiner als die Soll-Amplitude" generiert, wenn zu aufeinanderfolgenden Zeitpunkten 1_{auf} und 1_{ab} die Bedigngung B nicht vorliegt,
es wird ein Ausgangssignal "Offset von S2 ist zu groß" generiert, wenn zu aufeinanderfolgenden Zeitpunkten 1_{auf} die Bedingung B vorliegt und 1_{ab} die Bedingung B nicht vorliegt und
es wird ein Ausgangssignal "Offset von S2 ist zu klein" generiert, wenn zu aufeinanderfolgenden Zeitpunkten 1_{auf} die Bedingung B nicht vorliegt und 1_{ab} die Bedingung B vorliegt.

Gemäß der Erfindung wird die obengenannte Aufgabe bezüglich der gattungsgemäßen Schaltung dadurch gelöst, daß in einem Steuerwerk (SW) die folgende logische Verknüpfung vorgenommen wird:
Es wird ein Ausgangssignal "Amplitude von S1 ist größer als die Soll-Amplitude" generiert, wenn zu aufeinanderfolgenden Zeitpunkten 2_{auf} und 2_{ab} die Bedingung A vorliegt,
es wird ein Ausgangssignal "Amplitude von S1 ist kleiner als die Soll-Amplitude" generiert, wenn zu aufeinanderfolgenden Zeitpunkten 2_{auf} und 2_{ab} die Bedingung A nicht vorliegt,
es wird ein Ausgangssignal "Offset von S1 ist zu groß" generiert, wenn zu aufeinanderfolgenden Zeitpunkten 2_{auf} die Bedingung A vorliegt und 2_{ab} die Bedingung A nicht vorliegt,
es wird ein Ausgangssignal "Offset von S1 ist zu klein" generiert, wenn zu aufeinanderfolgenden Zeitpunkten 2_{auf} die Bedingung A nicht vorliegt und 2_{ab} die Bedingung A vorliegt,
es wird ein Ausgangssignal "Amplitude von S2 ist größer als die Soll-Amplitude" generiert, wenn zu aufeinanderfolgenden Zeitpunkten 1_{auf} und 1_{ab} die Bedingung B vorliegt,
es wird ein Ausgangssignal "Amplitude von S2 ist kleiner als die Soll-Amplitude" generiert, wenn zu aufeinanderfolgenden Zeitpunkten 1_{auf} und 1_{ab} die Bedingung B nicht vorliegt,
es wird ein Ausgangssignal "Offset von S2 ist zu groß" generiert, wenn zu aufeinanderfolgenden Zeitpunkten 1_{auf} die Bedingung B vorliegt und 1_{ab} die Bedingung B nicht vorliegt und
es wird ein Ausgangssignal "Offset von S2 ist zu klein" generiert, wenn zu aufeinanderfolgenden Zeitpunkten 1_{auf} die Bedingung B nicht vorliegt und 1_{ab} die Bedingung B vorliegt.

Eine besonders vorteilhafte Schaltung hierzu ist dadurch gekennzeichnet, daß jedes Auftreten einer positiven Halbwelle des Signals S1 bzw. des Signals S2 in der dritten bzw. vierten Schwellwertstufe ein für die Dauer dieser Halbwelle bestehendes Signal logisch "1" auslöst, dessen aufsteigende Flanke den Zeitpunkt 1_{auf} bzw. 2_{auf} angibt und dessen abfallende Flanke den Zeitpunkt 1_{ab} bzw. 2_{ab} angibt. Damit kann durch ein einziges binäres Signal, das in Form eines Blockes leicht generierbar ist, jeder gewünschte Zeitpunkt in technisch ausgesprochen einfacher Weise generiert werden.

Dadurch, daß die erste bzw. zweite Schwellwertstufe eingangsseitig eine Gleichrichterstufe aufweist, können sowohl der obere als auch der untere Maximalwert der Amplitude von einer einzigen Schwellwertstufe erfaßt werden.

Die leichte Detektierbarkeit der Amplituden- und/oder Offset-Abweichungen ermöglicht es auch, das Abweichungssignal für einen Regler einzusetzen, der das Signal S1 bzw. das Signal S2 offsetfrei auf die Soll-Amplitude regelt. Damit ist nicht nur eine Fehlererfassung, sondern auch eine Fehlerkompensation erreichbar.

Eine vorteilhafte Schaltung bei einem derartigen Regelvorgang ist dadurch gekennzeichnet, daß bei einem Regler, der das Signal S1 bzw. das Signal S2 offsetfrei auf die Soll-Amplitude regelt, diejenigen Ausgangssignale, die auf einen zu großen Zustand hinweisen, den jeweiligen zuständigen Zähler jeweils um einen definierten Wert rückzählen, daß diejenigen Ausgangssignale, die auf einen zu kleinen Zustand hinweisen, den jeweiligen Zähler um einen definierten Wert hochzählen, und daß die Ausgangssignale der Zähler als rückregelnde Stellgrößen vorgesehen sind. Damit ist gewährleistet, daß ein fortlaufender Regelvorgang erfolgt, weil ein stetiges Einpendeln des Zählerstandes mit jedem Vergleichsvorgang erfolgt.

Die Signalrückführung kann in technisch ausgesprochen einfacher Weise dadurch geschehen, daß Offset-Fehler durch eine Differenzbildung des Ausgangssignals des zugehörigen Zählers mit dem jeweiligen fehlerbehafteten Signal eliminiert werden und daß Amplitudenfehler durch eine Multiplikation des Ausgangssignals des zugehörigen Zählers mit dem jeweiligen zu korrigierenden Signal eliminiert werden. Prinzipiell ist es zwar in beiden Fällen möglich, mit dem digitalen Ausgangssignal der zugehörigen Zähler zu arbeiten, jedoch hat es sich in der Praxis als vorteilhaft erwiesen, daß die Offset-Fehlerausregelung dadurch erfolgt, daß das zu korrigierende Analogsignal durch eine Digital-Analog-Umsetzung des Zählerausgangssignals gebildet wird. Die Art der Digital-Analog Umsetzung ist dabei für die Erfindung nicht entscheidend. Möglich ist beispielsweise die Umformung des Digitalssignals zunächst in ein pulsbreiten-moduliertes Signal, dessen Mittelwert dann als Anologsignal für die weitere Verarbeitung zur Verfügung steht. Die Pulsbreitenmodulation kann beispielsweise durch Vergleich des Zählerstandes des jeweiligen Zähler mit einem sägezahnförmig verlaufenden Signal geschehen.

Ein Auführungsbeispiel der Erfindung ist in der Zeichnung dargestellt und wird im folgenden näher erläutert.

Dabei zeigen:
Figur 1 ein Blockschaltbild und
Figur 2 und 3 signifigante Signalverläufe.

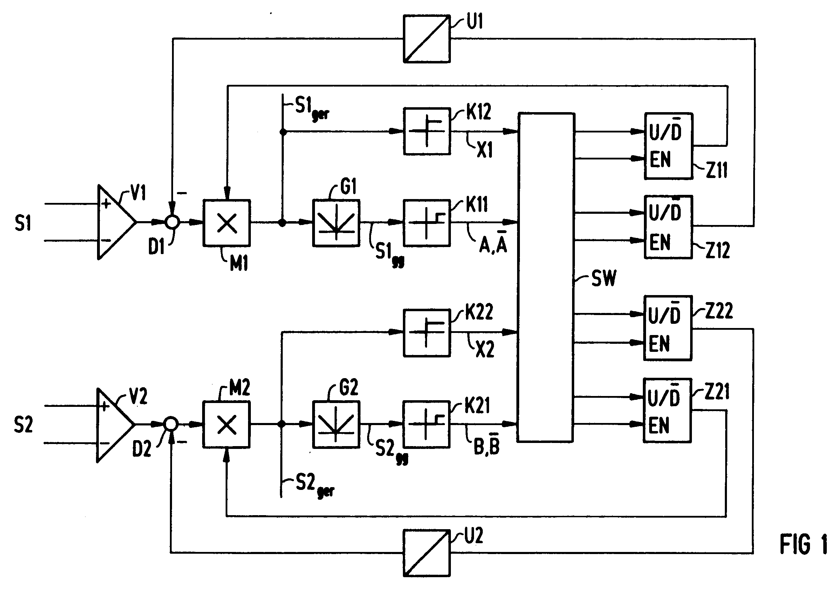

In der Darstellung gemäß Figur 1 wird ein sinusförmiges Signal S1 beispielsweise als Differenzsignal einem Verstärker V1 zugeleitet und ein weiteres sinusförmiges Signal S2 wird in gleicher Weise einem Verstärker V2 zugeführt. Die Signale S1 und S2 sind dabei im Idealfall von einer gleichen vorgegebenen Soll-Amplitude, sind ferner um 90° elektrisch versetzt und offsetfrei. Dieser Idealfall liegt allerdings nur in den wenigsten Fällen vor und so ist stets mit einem geringen Amplituden- und/oder Offset-Fehler zu rechnen.

Es ist ist nun Gegenstand der Schaltung gemäß Figur 1 sowohl den Amplituden-, wie auch den Offset-Fehler zu eliminieren. Dazu wird das Ausgangssignal des Verstärkers V1 über ein Differenzglied D1 und einen Multiplikator M1 geleitet und kann dann als entsprechend ausgeregeltes Signal S1_{ger} an der Übersichtlichkeit halber nicht dargestellte Weiterverarbeitungseinrichtungen geleitet werden.

In entsprechender Weise wird das Ausgangssignal des Verstärkers V2 über ein Differenzglied D2 und über einen Multiplikator M2 geführt, an dessen Ausgang ein geregeltes Signal S2_{ger} für die weiteren Verarbeitungseinrichtungen zur Verfügung steht.

Im folgenden sei zunächst von einer offenen Regelschleife ausgegangen, bei der das Signal S1 und das Signal S2 weder durch das Differenzglied D1 bzw. D2 um einen Differenzwert noch über den Multiplikator M1 bzw. M2 um einen Korrekturfaktor variiert wird. Das Signal S1 wird somit in unveränderter Form einem Komparator K12 zugeleitet, der stets dann, wenn eine positive Halbwelle des Signals S1 vorliegt, ein Binärsignal logisch "1" und ansonsten ein Binärsignal logisch "0" abgibt. Dieses jeweilige Signal wird im folgenden mit X1 bezeichnet.

Der Gleichrichter G1 richtet das Signal S1 gleich, so daß am Ausgang des Gleichrichters G1 das gleichgerichtete Signal S1_{gg} ansteht. Dieses Signal S1_{gg} gelangt an den Eingang eines Komparators K11, der stets dann, wenn das zugeführte Signal die vorgegebene Soll-Amplitude des Signals S1 überschreitet, ein Signal logisch "1" als Signal A an seinem Ausgang führt und anderfalls ein Signal logisch "0" als Signal A̅ abgibt. Die Ausgangssignale der Komparatoren K12 und K11 gelangen an ein Steuerwerk SW, das in gleicher Weise die mit Hilfe eines Gleichrichters G2 und von Komparatoren K21 und K22 aus dem Signal S2 direkt bzw. über dessen Gleichrichtung in ein Signal S2_{gg} indirekt gewonnenen Ausgangssignale X2 und B, B̅ generiert. Diese Ausgangssignale entsprechen daher prinzipiell den Signalen X1 und A, A̅.

Im Steuerwerk SW wird anhand von logischen Verknüpfungen der zugeführten Signale ermittelt, ob das Signal S1 bzw. S2 eine geringere oder eine größere Amplitude als der zugehörige Amplituden-Sollwert aufweist und ob ein zu großer oder ein zu geringer Offsetwert der Signale S1 bzw. S2 vorliegt. Sofern während eines Detektionsvorganges ermittelt wird, daß die Amplitude des Signals S1 zu groß ist, wird ein Zähler Z12 um einen Wert "1" in seinem Zählerstand erniedrigt, sofern die Amplitude des Signals S1 zu klein ist, wird der Zählerstand des Zählers Z12 um einen Wert "1" erhöht. In gleicher Art und Weise wird für das Signal S2 ein Zähler Z22 angesteuert. Dann, wenn der Offset des Signals S1 zu groß ist, wird ein Zähler Z11 um einen Wert "1" zurückgezählt, andernfalls, d. h. wenn der Offset zu klein ist, wird der Zähler Z11 um einen Wert "1" hochgezählt. In gleicher Art und Weise geschieht dies für das Signal S2 über einen Zähler Z21. Die Zähleingänge sind bei den Zählern Z11, Z12, Z21 und Z22 mit U/D̅ bezeichnet, ferner ist in der Darstellung ein Eingang EN bezeichnet, der vom Steuerwerk anzusteuern ist, um den jeweiligen Zähler Z11, Z12, Z21 bzw. Z22 zu aktivieren.

Das Ausgangssignal des Zählers Z12 zeigt anhand seines digitalen Zählwertes an, inwieweit die Amplitude des Signals S1 einer Korrektur bedarf. Um den eigentlichen Korrekturvorgang auszulösen, wird dieses Signal einem Umsetzer U1 zugeleitet, der als Digital-Analogwandler aus dem genannten Digitalwert ein Analogsignal gewinnt, welches dann bei geschlossener Regelschleife dem Differenzglied D1 zurückregelnd zugeleitet wird.

Das Ausgangssignal des Zählers Z11 gibt die Größe der Offsetabweichung an und dementsprechend kann dieses Digitalsignal verwendet werden um in einem Multiplikator M1 das Signal S1 zu korrigieren.

In entsprechender Weise kann auch für den Kanal des Signals S2 eine Rückregelung vom Zähler Z21 auf den Multiplikator M2 und vom Zähler Z22 über einen Umsetzer U2 auf das Differenzglied D2 erfolgen.

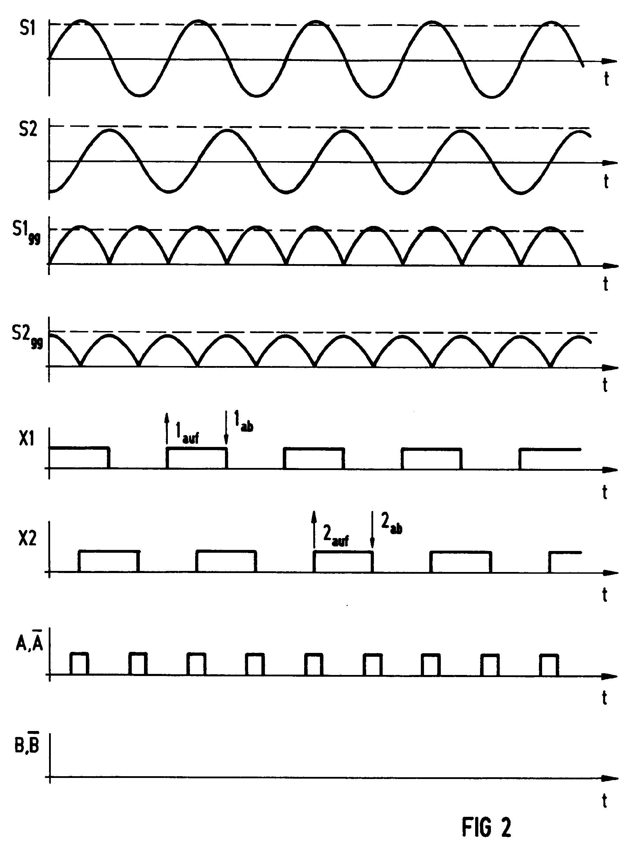

In der Darstellung gemäß Figur 2 wird die Funktion der Einrichtung gemäß Figur 1 anhand einiger signifikanter Signalverläufe geschildert, wobei angenommen ist, daß ein Amplituden-Fehler vorliegt, bei dem das Signal S1 größer als die vorgesehene Soll-Amplitude ist, die in den zeitgleichen Darstellungen jeweils durch gestrichelte Linien angedeutet ist, und wobei das Signal S2 kleiner als eben diese Soll-Amplitude ist. In der obersten Darstellung von Figur 2 ist das Signal S1 sozusagen als Rohsignal mit seinem Verlauf dargestellt. Im darunterliegenden Signalverlauf ist in entsprechender Weise das Signal S2 dargestellt. Es folgt dann eine Darstellung des gleichgerichteten Signals S1, d. h. des Signals S1_{gg}, sowie eine Darstellung des gleichgerichteten Signals S2, d. h. des Signals S2_{gg}. Ferner sind die bereits in Figur 1 angeführten Signale X1 und X2 sowie die Signale A, A̅ und B, B̅ in ihrem zeitlichen Verlauf gezeigt. Bei der vorliegenden zeitlichen Koinzidenz der einzelnen Signalverläufe zeigt es sich, daß mit jeder positiven Halbwelle des Signals S1 das Signal X1 einen Wert logisch "1" annimmt und daß mit jeder positiven Halbwelle des Signals S2 das Signal X2 einen Wert logisch "1" hat.

Von den Erfindern ist nun erkannt worden, daß mit dem Nulldurchgang des Signals S2 jeweils ein Zeitpunkt definiert wird, zu dem leicht abgefragt werden kann, ob das Signal S1 mit seinem Scheitel über dem Sollwert liegt oder nicht, und daß in gleicher Weise der Nulldurchgang des Signals S1 jeweils Zeitpunkte bestimmt, zu denen in einfacher Weise festgestellt werden kann, ob das Signal S2 oberhalb oder unterhalb der Soll-Amplitude liegt. Auch ein leichter zeitlicher Versatz der Nulldurchgänge führt aufgrund des flachen Signalverlaufs im Scheitel der Signale nämlich dazu, daß eindeutige Bewertungskriterien möglich sind.

Dem oben Dargelegten ist entnehmbar, daß jeweils die aufsteigenden bzw. abfallenden Flanken der Signale X1 und X2 die Triggerzeitpunkte für das System festlegen. In den Darstellungen für die Signale X1 und X2 ist für zwei beliebige Blöcke der jeweiligen Signale jeweils der Zeitpunkt eines positiven Nulldurchgangs des Signals S1 als 1_{auf} und des negativen Signaldurchgangs des Signals S1 als 1_{ab} durch jeweils einen Pfeil dargestellt. Entsprechendes gilt für das Signal X2, bei dem die entsprechenden positiven und negativen Nulldurchgänge des Signals S2 in den Blöcken des Signals X2 die Zeitpunkte 2_{auf} und 2_{ab} angeben.

Die beiden unteren Diagramme in Figur 2 zeigen den Verlauf des Ausgangssignales des Komperators K11 und des Komperators K21 von Figur 1, wobei ersichtlich ist, daß stets dann, wenn die Soll-Amplitude vom Signal S1 überschritten wird, ein Signal logisch "1" als Signal A vorliegt und ansonsten ein Signal logisch "0" als Signal A̅ ansteht. Da das Signal S2 beim angenommenen Ausführungsbeispiel die Soll-Amplitude nie überschreitet, liegt dabei stets ein Signal logisch "0" als Signal B̅ vor.

Das Steuerwerk SW beinhaltet nun folgende logische Verknüpfung. Es wird ein Ausgangssignal "Amplitude von S1 ist größer als die Soll-Amplitude" generiert, wenn zu aufeinanderfolgenden Zeitpunkten 2_{auf} und 2_{ab} die Bedingung A vorliegt. Es wird ein Ausgangssigal "Amplitude von S1 ist kleiner als die Soll-Amplitude" generiert, wenn zu aufeinanderfolgenden Zeitpunkten 2_{auf} und 2_{ab} die Bedingung A nicht vorliegt, d.h., daß dann die Bedingung A̅ vorliegt.

Für den das Signal S2 führenden Kanal gilt entsprechendes; d.h., es wird ein Ausgangssignal "Amplitude von S2 ist größer als die Soll-Amplitude" generiert, wenn zu aufeinanderfolgenden Zeitpunkten 1_{auf} und 1_{ab} die Bedingung B vorliegt und es wird ein Ausgangssignal "Amplitude von S2 ist kleiner als die Soll-Amplitude" generiert, wenn zu aufeinanderfolgenden Zeitpunkten 1_{auf} und 1_{ab} die Bedingung B nicht vorliegt, d.h., daß dann die Bedingung B̅ vorliegt. Stets mit dem Ermitteln dieser Bedingungen wird der zugeordnete Zähler Z12 bzw. Z21 wirksamgeschaltet und der Zählerstand wird in positiver bzw. negativer Richtung korrigiert.

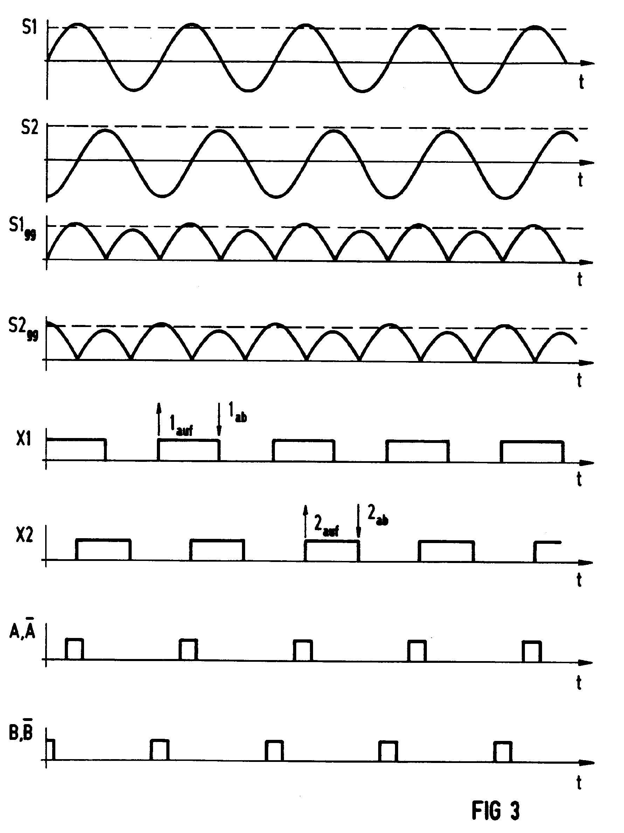

In der Darstellung gemäß Figur 3 sind die obenbezeichneten Signalverläufe für den Fall gezeigt, daß das Signal S1 einen zu hohen Offsetwert aufweist.

Die logische Verknüpfung der dargestellten Signale im Steuerwerk SW geschieht dabei so, daß folgende Bedingungen eingehalten werden. Es wird ein Ausgangssignal "Offset von S1 ist zu groß" generiert, wenn zu aufeinander folgenden Zeitpunkten 2_{auf} die Bedingung A vorliegt und 2 _{ab} die Bedingung A nicht vorliegt, d.h. die Bedingung A̅ besteht. (Dieses Fall ist - wie eingangs dargelegt -im Ausführungsbeispiel gemäß Figur 3 gegeben.) Es würde ein Ausgangssignal "Offset von S1 ist zu klein" generiert, wenn zu aufeinanderfolgenden Zeitpunkten 2_{auf} die Bedingung A nicht vorliegt (A̅) und 2_{ab} die Bedingung A vorliegt. In entsprechender Weise gilt für das Signal S2, daß eine Ausgangssignal "Offset von S2 ist zu groß" generiert wird, wenn zu aufeinanderfolgenden Zeitpunkten 1_{auf} die Bedingung B vorliegt und 1_{ab} die Bedingung B nicht vorliegt (B̅) und daß ein Ausgangssignal "Offset von S2 ist zu klein" generiert wird, wenn zu aufeinanderfolgenden Zeitpunkten 2 _{auf} die Bedingung B nicht vorliegt (B̅) und 1_{ab} die Bedingung B vorliegt.

## Patentansprüche

1. Verfahren zum Detektieren einer Amplituden- und Offset-Abweichung zweier gleichartiger, um etwa 90° elektrisch versetzter sinusförmiger Signale S1 und S2 mit vorgegebener Soll-Amplitude mit folgenden Verfahrensschritten, daß eine erste Schwellwertstufe (G1,K11) ein erstes Kennsignal als Bedingung A stets solange liefert, wie das Signal S1 die vorgegebene Soll-Amplitude überschreitet, daß eine zweite Schwellwertstufe (G2,K21) ein zweites Kennsignal als Bedingung B stets solange liefert, wie das Signal S2 die vorgegebene Soll-Amplitude überschreitet, daß durch eine dritte Schwellwertstufe (K12) der Nulldurchgang des Signals S1 sowohl in aufsteigender als auch in absteigender Richtung zu Zeitpunkten 1_{auf} bzw. 1_{ab} detektierbar ist und daß durch eine vierte Schwellwertstufe (K22) der Nulldurchgang des Signals S2 sowohl in aufsteigender als auch in absteigender Richtung zu Zeitpunkten 2_{auf} bzw. 2_{ab} detektierbar ist, **dadurch gekennzeichnet,** daß in einem Steuerwerk (SW) die folgende logische Verknüpfung vorgenommen wird:
Es wird ein Ausgangssignal "Amplitude von S1 ist größer als die Soll-Amplitude" generiert, wenn zu aufeinanderfolgenden Zeitpunkten 2_{auf} und 2_{ab} die Bedingung A vorliegt,
es wird ein Ausgangssignal "Amplitude von S1 ist kleiner als die Soll-Amplitude" generiert, wenn zu aufeinanderfolgenden Zeitpunkten 2_{auf} und 2_{ab} die Bedingung A nicht vorliegt,
es wird ein Ausgangssignal "Offset von S1 ist zu groß" generiert, wenn zu aufeinanderfolgenden Zeitpunkten 2_{auf} die Bedingung A vorliegt und 2_{ab} die Bedingung A nicht vorliegt,
es wird ein Ausgangssignal "Offset von S1 ist zu klein" generiert, wenn zu aufeinanderfolgenden Zeitpunkten 2_{auf} die Bedingung A nicht vorliegt und 2_{ab} die Bedingung A vorliegt,
es wird ein Ausgangssignal "Amplitude von S2 ist größer als die Soll-Amplitude" generiert, wenn zu aufeinanderfolgenden Zeitpunkten 1_{auf} und 1_{ab} die Bedingung B vorliegt,
es wird ein Ausgangssignal "Amplitude von S2 ist kleiner als die Soll-Amplitude" generiert, wenn zu aufeinanderfolgenden Zeitpunkten 1_{auf} und 1_{ab} die Bedingung B nicht vorliegt,
es wird ein Ausgangssignal "Offset von S2 ist zu groß" generiert, wenn zu aufeinanderfolgenden Zeitpunkten 1_{auf} die Bedingung B vorliegt und 1_{ab} die Bedingung B nicht vorliegt und
es wird ein Ausgangssignal "Offset von S2 ist zu klein" generiert, wenn zu aufeinanderfolgenden Zeitpunkten 1_{auf} die Bedingung B nicht vorliegt und 1_{ab} die Bedingung B vorliegt.

2. Schaltung zum Detektieren einer Amplituden- und Offset-Abweichung zweier gleichartiger, um etwa 90° elektrisch versetzter sinusförmiger Signale S1 und S2 mit vorgegebener Soll-Amplitude mit folgenden Merkmalen , daß eine erste Schwellwertstufe (G1,K11) ein erstes Kennsignal als Bedingung A stets solange liefert, wie das Signal S1 die vorgegebene Soll-Amplitude überschreitet, daß eine zweite Schwellwertstufe (G2,K21) ein zweites Kennsignal als Bedingung B stets solange liefert, wie das Signal S2 die vorgegebene Soll-Amplitude überschreitet, daß durch eine dritte Schwellwertstufe (K12) der Nulldurchgang des Signals S1 sowohl in aufsteigender als auch in absteigender Richtung zu Zeitpunkten 1_{auf} bzw. 1_{ab} detektierbar ist und daß durch eine vierte Schwellwertstufe (K22) der Nulldurchgang des Signals S2 sowohl in aufsteigender als auch in absteigender Richtung zu Zeitpunkten 2_{auf} bzw. 2_{ab} detektierbar ist, **dadurch gekennzeichnet,** daß in einem Steuerwerk (SW) die folgende logische Verknüpfung vorgenommen wird:
Es wird ein Ausgangssignal "Amplitude von S1 ist größer als die Soll-Amplitude" generiert, wenn zu aufeinanderfolgenden Zeitpunkten 2_{auf} und 2_{ab} die Bedingung A vorliegt,
es wird ein Ausgangssignal "Amplitude von S1 ist kleiner als die Soll-Amplitude" generiert, wenn zu aufeinanderfolgenden Zeitpunkten 2_{auf} und 2_{ab} die Bedingung A nicht vorliegt,
es wird ein Ausgangssignal "Offset von S1 ist zu groß" generiert, wenn zu aufeinanderfolgenden Zeitpunkten 2_{auf} die Bedingung A vorliegt und 2_{ab} die Bedingung A nicht vorliegt,
es wird ein Ausgangssignal "Offset von S1 ist zu klein" generiert, wenn zu aufeinanderfolgenden Zeitpunkten 2_{auf} die Bedingung A nicht vorliegt und 2_{ab} die Bedingung A vorliegt,
es wird ein Ausgangssignal "Amplitude von S2 ist größer als die Soll-Amplitude" generiert, wenn zu aufeinanderfolgenden Zeitpunkten 1_{auf} und 1_{ab} die Bedingung B vorliegt,
es wird ein Ausgangssignal "Amplitude von S2 ist kleiner als die Soll-Amplitude" generiert, wenn zu aufeinanderfolgenden Zeitpunkten 1_{auf} und 1_{ab} die Bedingung B nicht vorliegt,
es wird ein Ausgangssignal "Offset von S2 ist zu groß" generiert, wenn zu aufeinanderfolgenden Zeitpunkten 1_{auf} die Bedingung B vorliegt und 1_{ab} die Bedingung B nicht vorliegt und
es wird ein Ausgangssignal "Offset von S2 ist zu klein" generiert, wenn zu aufeinanderfolgenden Zeitpunkten 1_{auf} die Bedingung B nicht vorliegt und 1_{ab} die Bedingung B vorliegt.

3. Schaltung nach Anspruch 2, **dadurch gekennzeichnet**, daß jedes Auftreten einer positiven Halbwelle des Signals S1 bzw. des Signals S2 in der dritten (K12) bzw. vierten Schwellwertstufe (K22) ein für die Dauer dieser Halbwelle bestehendes Signal logisch "1" auslöst, dessen aufsteigende Flanke den Zeitpunkt 1_{auf} bzw. 2_{auf} angibt und dessen abfallende Flanke den Zeitpunkt 1_{ab} bzw. 2_{ab} angibt.

4. Schaltung nach Anspruch 2 oder 3, **dadurch gekennzeichnet,** daß die erste (G1,K11) bzw. zweite Schwellwertstufe (G2,K21) eingangsseitig eine Gleichrichterstufe (G1,G2) aufweist.

5. Schaltung nach Anspruch 2, 3 oder 4, **dadurch gekennzeichnet,** daß bei einem Regler, der das Signal S1 bzw. das Signal S2 offsetfrei auf die Soll-Amplitude regelt, diejenigen Ausgangssignale, die auf einen zu großen Zustand hinweisen, den jeweiligen zuständigen Zähler (Z11,Z12,Z21,Z22) jeweils um einen definierten Wert rückzählen, daß diejenigen Ausgangssignale, die auf einen zu kleinen Zustand hinweisen, den jeweiligen Zähler (Z11,Z12, Z21,Z22) um einen definierten Wert hochzählen, und daß die Ausgangssignale der Zähler (Z11,Z12,Z21,Z22) als rückregelnde Stellgrößen vorgesehen sind.

6. Schaltung nach Anspruch 5, **dadurch gekennzeichnet,** daß Offset-Fehler durch eine Differenzbildung des Ausgangssignals des zugehörigen Zählers (Z12,Z22) mit dem jeweiligen fehlerbehafteten Signal S1 bzw. S2 eliminiert werden.

7. Schaltung nach Anspruch 6, **dadurch gekennzeichnet,** daß ein korrigierendes Analogsignal durch eine Digital/Analog-Umsetzung des Ausgangssignals des zugehörigen Zählers (Z12,Z22) gebildet wird.

8. Schaltung nach Anspruch 5, 6 oder 7, **dadurch gekennzeichnet,** daß Amplituden-Fehler durch eine Multiplikation des Ausgangssignals des zugehörigen Zählers (Z11,Z21) mit dem jeweiligen zu korrigierenden Signal S1 bzw. S2 eliminiert werden.

## Claims

1. Method for detecting an amplitude deviation and an offset deviation of two similar sinusoidal signals S1 and S2 out of phase by approximately 90°, with a pre-determined reference amplitude, comprising the following method steps:
- a first threshold stage (G1, K11) constantly delivers a first characteristic signal as condition A so long as the signal S1 exceeds the pre-determined reference amplitude,
- a second threshold stage (G2, K21) constantly delivers a second characteristic signal as condition B so long as the signal S2 exceeds the pre-determined reference amplitude,
- the zero passage of the signal S1 can be detected by means of a third threshold stage (K12) both in the upward direction and in the downward direction at times 1ᵤₚ and i_{down}, respectively, and
- the zero passage of the signal S2 can be detected by means of a fourth threshold stage (K22) both in the upward direction and in the downward direction at times 2ᵤₚ and 2_{down}, respectively,
characterised in that, in a control unit (SW), the following logic linking takes place:
- an output signal "amplitude of S1 is greater than the reference amplitude" is generated if condition A occurs at consecutive times 2ᵤₚ and 2_{down},
- an output signal "amplitude of S1 is less than the reference amplitude" is generated if condition A fails to occur at consecutive times 2ᵤₚ and 2_{down},
- an output signal "offset of S1 is too great" is generated if condition A occurs at time 2ᵤₚ and condition A fails to occur at time 2_{down}, with these times being consecutive,
- an output signal "offset of S1 is too small" is generated if condition A fails to occur at time 2ᵤₚ and condition A occurs at time 2_{down}, with these times being consecutive,
- an output signal "amplitude of S2 is greater than the reference amplitude" is generated if condition B occurs at consecutive times 1ᵤₚ and 1_{down},
- an output signal "amplitude of S2 is less than the reference amplitude" is generated if condition B fails to occur at successive times 1ᵤₚ and 1_{down},
- an output signal "offset of S2 is too great" is generated if condition B occurs at time 1ᵤₚ and condition B fails to occur at time 1_{down}, with these times being consecutive, and
- an output signal "offset of S2 is too small" is generated if condition B fails to occur at time 1ᵤₚ and condition B occurs at time 1_{down}, with these times being consecutive.

2. Circuit for detecting an amplitude deviation and an offset deviation of two similar sinusoidal signals S1 and S2 out of phase by approximately 90°, with a pre-determined reference amplitude, having the following features:
- a first threshold stage (G1, K11) constantly delivers a first characteristic signal as condition A so long as the signal S1 exceeds the pre-determined reference amplitude,
- a second threshold stage (G2, K21) constantly delivers a second characteristic signal as condition B so long as the signal S2 exceeds the pre-determined reference amplitude,
- the zero passage of the signal S1 can be detected by means of a third threshold stage (K12) both in the upward direction and in the downward direction at times 1ᵤₚ and 1_{down}, respectively, and
- the zero passage of the signal S2 can be detected by means of a fourth threshold stage (K22) both in the upward and in the downward direction at times 2ᵤₚ and 2_{down}, respectively
characterised in that, in a control unit (SW), the following logic linking is carried out:
- an output signal "amplitude of S1 is greater than the reference amplitude" is generated if condition A occurs at consecutive times 2ᵤₚ and 2_{down},
- an output signal "amplitude of S1 is less than the reference amplitude" is generated if condition A fails to occur at consecutive times 2ᵤₚ and 2_{down},
- an output signal "offset of S1 is too great" is generated if condition A occurs at time 2ᵤₚ and condition A fails to occur at time 2_{down}, with these times being consecutive,
- an output signal "offset of S1 is too small" is generated if condition A fails to occur at time 2ᵤₚ and condition A occurs at time 2_{down}, with these times being consecutive,
- an output signal "amplitude of S2 is greater than the reference amplitude" is generated if condition B occurs at consecutive times 1ᵤₚ and 1_{down},
- an output signal "amplitude of S2 is less than the reference amplitude" is generated if condition B fails to occur at consecutive times 1ᵤₚ and 1_{down},
- an output signal "offset of S2 is too great" is generated if condition B occurs at time 1ᵤₚ and condition B fails to occur at time 1_{down}, with these times being consecutive, and
- an output signal "offset of S2 is too small" is generated if condition B fails to occur at time 1ᵤₚ and condition B occurs at time 1_{down}, with these times being consecutive.

3. Circuit according to claim 2, characterised in that each occurrence of a positive half-wave of the signal S1 and of the signal S2, respectively, in the third (K12) and fourth threshold stage (K22), respectively, triggers a logic "1" signal existing for the duration of this half-wave, with the rising edge of the logic "1" signal indicating the time 1ᵤₚ and 2ᵤₚ, respectively, and the falling edge of the logic "1" signal indicating the time 1_{down} and 2_{down}, respectively.

4. Circuit according to claim 2 or 3, characterised in that the first threshold stage (G1, K11) and the second threshold stage (G2, K21), respectively, have a rectifier stage (G1, G2) on the input side.

5. Circuit according to claim 2, 3 or 4, characterised in that, in a regulator which regulates the signal S1 and the signal S2, respectively, offset-free to the reference amplitude, the output signals which indicate an unacceptably high condition cause the respective corresponding counter (Z11, Z12, Z21, 222) to count down by a defined value in each case, in that the output signals which indicate an unacceptably low condition cause the respective counter (Z11, Z12, Z21, Z22) to count up by a defined value, and in that the output signals of the counters (Z11, Z12, Z21, Z22) are provided as retro-regulating manipulated variables.

6. Circuit according to claim 5, characterised in that offset errors are eliminated by forming the difference of the output signal of the associated counter (Z12, Z22) with the respective signal S1 and S2 containing the error.

7. Circuit according to claim 6, characterised in that a correcting (sic) analog signal is formed by means of a digital-to-analog conversion of the output signal of the associated counter (Z12, Z22).

8. Circuit according to claim 5, 6 or 7, characterised in that amplitude errors are eliminated by multiplication of the output signal of the associated counter (Z11, Z21) with the respective signal S1 and S2 to be corrected.

## Revendications

1. Procédé de détection d'un écart d'amplitude ou de décalage de deux signaux S1 et S2 sinusoïdaux, qui sont du même genre et qui ont une amplitude prescrite de consigne, par les étapes suivantes : un premier étage (G1, K11) à seuil fournit constamment un premier signal caractéristique comme condition A, tant que le signal S1 dépasse l'amplitude prescrite de consigne, un deuxième étage (G2, K21) à seuil fournit constamment un deuxième signal caractéristique comme condition B, tant que le signal S2 dépasse l'amplitude prescrite de consigne, le passage par zéro du signal S1 à la fois dans le sens croissant et dans le sens décroissant peut être détecté par un troisième étage (K12) à seuil aux instants 1_{auf} et 1_{ab} et le passage par zéro du signal S2 à la fois dans le sens croissant et dans le sens décroissant peut être détecté par un quatrième étage (K22) à seuil aux instants 2_{auf} et 2_{ab}, caractérisé en ce que l'on effectue dans une unité SW de commande la combinaison logique suivante :
on génère un signal de sortie "l'amplitude de S1 est plus grande que l'amplitude de consigne", lorsque la condition A est vérifiée aux instants successifs 2_{auf} et 2_{ab},
on génère un signal de sortie "l'amplitude de S1 est plus petite que l'amplitude de consigne", lorsque la condition A n'est pas vérifiée aux instants successifs 2_{auf} et 2_{ab},
on génère un signal de sortie "le décalage de S1 est trop grand", lorsque à l'instant 2_{auf} la condition A est vérifiée et à l'instant 2_{ab} successif la condition A n'est pas vérifiée,
on génère un signal de sortie "le décalage de S1 est trop petit", lorsque la condition A n'est pas remplie à l'instant 2auf et la condition A est remplie à l'instant 2_{ab},
on génère un signal de sortie "l'amplitude de S2 est plus grande que l'amplitude de consigne", lorsque la condition B est remplie aux instants successifs 1_{auf} et 1_{ab},
on génère un signal de sortie "l'amplitude de S2 est plus petite que l'amplitude de consigne", lorsque la condition B n'est pas vérifiée aux instants successifs 1_{auf} et 1_{ab},
on génère un signal de sortie "le décalage de S2 est trop grand", lorsque la condition B est vérifiée à l'instant 1_{auf} et la condition B n'est pas vérifiée à l'instant successif 1_{ab} et
on génère un signal de sortie "le décalage de S2 est trop petit", lorsque la condition B n'est pas vérifiée à l'instant 1_{auf} et la condition B est vérifiée à l'instant successif 1_{ab}.

2. Circuit de détection d'un écart d'amplitude et de décalage de deux signaux sinusoïdaux S1 et S2, qui sont du même genre, qui sont décalés de 90° et qui ont une amplitude prescrite de consigne, ayant les particularités suivantes :
un premier étage (G1, K11) à seuil fournit constamment un premier signal caractéristique comme condition A, tant que le signal S1 dépasse l'amplitude prescrite de consigne, un deuxième étage (G2, K21) à seuil fournit constamment un deuxième signal caractéristique comme condition B, tant que le signal S2 dépasse l'amplitude prescrite de consigne, le passage par zéro du signal S1 à la fois dans le sens croissant et dans le sens décroissant peut être détecté par un troisième étage (K12) à seuil aux instants 1_{auf} et 1_{ab} et le passage par zéro du signal S2 à la fois dans le sens croissant et dans le sens décroissant peut être détecté par un quatrième étage (K22) à seuil aux instants 2_{auf} et 2_{ab}, caractérisé par le fait qu'il s'effectue dans une unité (SW) de commande la combinaison logique suivante :
un signal de sortie "l'amplitude de S1 est plus grande que l'amplitude de consigne" est généré, lorsque la condition A est vérifiée aux instants successifs 2_{auf} et 2_{ab},
un signal de sortie "l'amplitude de S1 est plus petite que l'amplitude de consigne" est généré, lorsque la condition A n'est pas vérifiée aux instants successifs 2_{auf} et 2_{ab},
un signal de sortie "le décalage de S1 est trop grand" est généré, lorsque la condition A est vérifiée à l'instant 2_{auf} et la condition A n'est pas vérifiée à l'instant successif 2_{ab},
un signal de sortie "le décalage de S1 est trop petit" est généré, lorsque la condition A n'est pas vérifiée à l'instant 2_{auf} et la condition A est vérifiée à l'instant successif 2_{ab},
un signal de sortie "l'amplitude de S2 est plus grande que l'amplitude de consigne" est généré, lorsque la condition B est vérifiée aux instants 1_{auf} et 1_{ab},
un signal de sortie "l'amplitude de S2 est plus petite que l'amplitude de consigne" est généré, lorsque la condition B n'est pas vérifiée aux instants successifs 1_{auf} et 1_{ab},
un signal de sortie "le décalage de S2 est trop grand" est généré, lorsque la condition B est vérifiée à l'instant 1_{auf} et la condition B n'est pas vérifiée à l'instant 1_{ab} successif et
un signal de sortie "le décalage de S2 est trop petit" est généré, lorsque la condition B n'est pas vérifiée à l'instant 1_{auf} et la condition B est vérifiée à l'instant successif 1_{ab}.

3. Circuit suivant la revendication 2, caractérisé en ce que chaque apparition d'une alternance positive du signal S1 et du signal S2 dans les troisième (K12) et quatrième (K22) étages à seuil déclenche un signal logique "1", qui persiste pendant la durée de cette alternance, dont le front montant indique l'instant 1_{auf} et 2_{auf} et dont le front descendant indique l'instant 1_{ab} et 2_{ab}.

4. Montage suivant la revendication 2 ou 3, caractérisé en ce que les premier (G1, K11) et second (G1, K21) étages à seuil comportent côté entrée un étage (G1, G2) redresseur.

5. Circuit suivant la revendication 2, 3 ou 4, caractérisé en ce que dans un régulateur, qui règle le signal S1 et le signal S2 sans décalage à l'amplitude de consigne, ceux des signaux de sortie, qui indiquent un état trop grand, décrémentent le compteur correspondant (Z11, Z12, Z21, Z22), d'une valeur définie, ceux des signaux de sortie, qui indiquent un état trop petit, incrémentent le compteur associé (Z11, Z12, Z21, Z22) d'une valeur définie et les signaux de sortie des compteurs (Z11, Z12, Z21, Z22) sont prévus comme grandeurs réglantes de retour.

6. Circuit suivant la revendication 5, caractérisé en ce que les erreurs de décalage sont éliminées en formant une différence entre le signal de sortie du compteur associé (Z12, Z22) et le signal S1 et S2 erroné associé.

7. Circuit suivant la revendication 6, caractérisé en ce qu'un signal analogique correcteur est formé par conversion numérique/analogique du signal de sortie du compteur (Z12, Z22) associé.

8. Circuit suivant la revendication 5, 6 ou 7, caractérisé en ce que des erreurs d'amplitude sont éliminées par multiplication du signal de sortie du compteur associé (Z11, Z21) par le signal S1 ou S2 respectif à corriger.
